Europäisches Patentamt

European Patent Office

Office européen des brevets

(11) Publication number: **0 471 386 A2**

# EUROPEAN PATENT APPLICATION

(21) Application number: **91115895.4**

(22) Date of filing: **31.10.85**

(51) Int. Cl.5: **H05K 3/22**

This application was filed on 19 - 09 - 1991 as a divisional application to the application mentioned under INID code 60.

(30) Priority: **02.11.84 US 667884**
**21.02.85 US 703942**

(43) Date of publication of application:
**19.02.92 Bulletin 92/08**

(60) Publication number of the earlier application in accordance with Art.76 EPC: **0 180 220**

(84) Designated Contracting States:
**CH FR GB IT LI SE**

(71) Applicant: **AMP-AKZO CORPORATION**
**710 Dawson Drive**
**Newark, Delaware 197113(US)**

(72) Inventor: **Frisch, David C.**
**476 Seaman Avenue**
**Baldwin, NY 11510(US)**
Inventor: **Weber, Wilhelm**
**54 Ninth Street**
**Hicksville, NY 11801(US)**

(74) Representative: **Königseder geb. Egerer,**
**Claudia**
**Zugspitzstrasse 65**
**W-8104 Grainau(DE)**

(54) **Process for the preparation of conductive patterns on thermoplastic polymer base substrates.**

(57) A new improved method for the production of printed wiring conductors on thermoplastic base material is described. The thermoplastic base material contains less than 0.1% of volatiles having boiling points below 245°C and the conductors are firmly anchored by carefully solvating the base material surface to such degree that it flows against and adheres to the edges of the conductors, but insufficient to permit the solvated base material to flow onto the conductors.

FIG. 1A

EP 0 471 386 A2

This invention relates to the manufacture of etched metal patterns and printed circuit conductors on metal clad thermoplastic polymer substrates.

High temperature engineering thermoplastics such as polysulfones, polyethersulfones, polyarylsulfones and polyetherimides have excellent dielectric properties.

Many processes have been proposed for producing printed circuit conductors or patterns on metal clad thermoplastic materials. One of the shortcomings of the prior art processes is the resulting bond strength between formed metal patterns or printed circuit conductors and the thermoplastic polymer substrate.

It is an object of this invention to enhance this bond strength.

The process of this invention for the preparation of an etched metal pattern or printed wiring conductors on thermoplastic polymer base substrates comprises the steps of providing the metal clad thermoplastic substrate with at least one plated-through hole; removing unwanted portions of the metal cladding thus forming the metal pattern or printed wiring conductors; contacting the substrate with a solvent in which the said substrate material is at least partially soluble for a time period sufficient to permit the solvated substrate material to flow against and adhere to the edges of the metal pattern or printed wiring conductors, but insufficient to permit the solvated substrate material to flow onto the metal pattern or printed wiring conductors; and immediately evaporating the solvent from the surface of the substrate at a temperature at which the solvent rapidly volatilizes to stop said flow, leaving the edges of the metal pattern or printed wiring conductors adhered to the surface of the substrate at their intersection.

Applicant has found that, subsequent to the removal of the unwanted metal, the bond strength of the metal pattern, especially the small conductors of a printed wiring conductor pattern, us enhanced by contacting the exposed surface of the substrate with a solvent for the substrate material and then rapidly evaporating the solvent from the surface in order to flow some of the substrate material against the edges of the conductors. The surface is contacted with the solvent for a time period brief enough to prevent crazing of the surface or flow of solvated substrate material over the conductors. Evaporation is accomplished at temperatures high enough to rapidly remove the solvent and sufficient to secure a bond between the substrate and the edges of the conductors.

The thus achieved enhancement of bond strength may be accomplished by immersing the polymer base material in a solvent in which the polymer is at least partially soluble and for a time period sufficient to solvate the polymer surface but insufficient to result in stress cracking or flow of the polymer onto the metal pattern or conductors. The time period will vary between about 1 second and about 1 minute, depending on the solvent system selected and the polymer system being treated. Suitable solvent systems include a strong solvent for polymer and suitable diluents. Among the diluents are aliphatic hydrocarbons, aliphatic alcohols and water. Immediately after being contacted with the solvent, the polymer surface is dried at a temperature at which the solvent rapidly volatilizes. The drying temperature is from room temperature up to about 200°C depending upon the polymers and the solvent systems used. Preferably, the drying temperature is between room temperature and 125°C.

The immersion may be in a liquid solvent such as ketones. esters, aromatic or aprotic solvents, or in solvent vapors or halogenated hydrocarbons with boiling points below the heat distortion temperature of the polymer.

Immediately upon removal of the polymeric substrate from exposure to the solvent, the polymeric substrate should be dried. Convection or infrared/convection oven combinations may be employed for drying. Solvating the surface enables the surface region of the thermoplastic base material to flow against the edges of the metal pattern or conductors. The application of heat in drying the solvated surface improves the flow. Drying temperatures, after exposure to liquid solvents, are preferably between about 60°C and about 200°C.

Prolonged delays after discontinuing solvent exposure and before beginning drying will give rise to a light haze or frosting conditions. Properly treated surfaces will appear smooth and even translucent or transparent in the case of unfilled or unpigmented high temperature thermoplastics which are translucent or transparent prior to laminating metal to their surface. Similarly, if a high temperature thermoplastic initially contains a pigment, treatment of its exposed surface will restore its initial color.

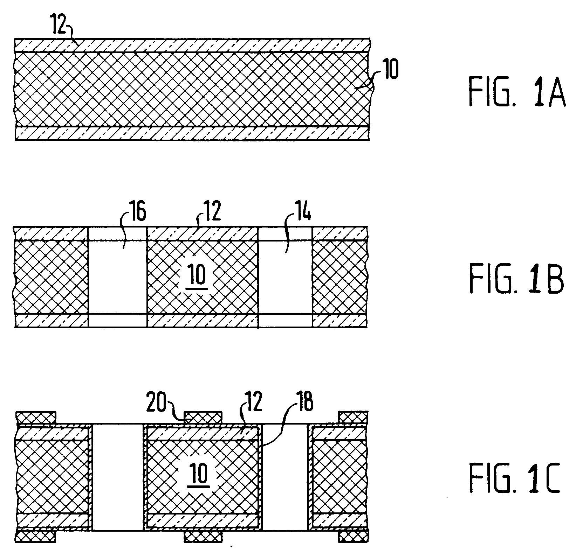

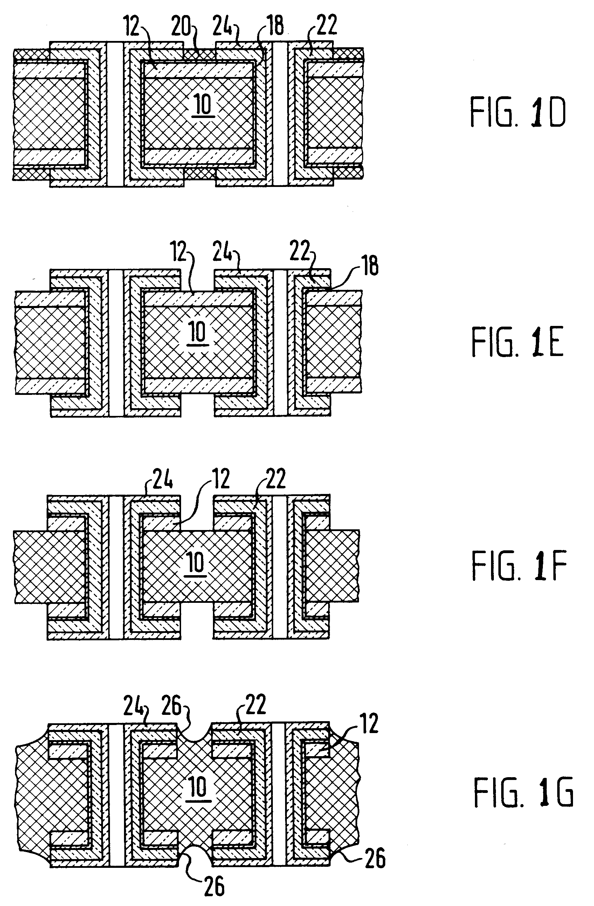

Figures 1A to 1G show a side view, in cross section, of the manufacturing steps of one embodiment of this invention. Fig. 1A shows an insulating blank 10 bonded on both sides with copper foil 12. The blank 10 comprises a sulfone polymer.

Fig. 1B shows holes 14 and 16 drilled through the blank 10. As shown in Fig. 1C, after holes 14 and 16 are produced, the blank 10, including the hole walls, is metallized with a thin layer of electrolessly deposited copper 18 and printed with a negative resist image 20 for pattern plating.

In Fig. 1D, the blank 10 is plated electrolytically with a copper layer 22 and a tin-lead alloy layer 24.

As shown in Fig. 1E, the resist 20 has been removed exposing the underlying copper foil 12 which will be subsequently etched in the next step.

In Fig. 1F, the blank 10 has been immersed in a copper etching solution wherein the copper foil 12 is chemically dissolved thereby delineating the desired circuit conductor pattern.

As shown in Fig. 1G, the blank 10 has been immersed in a solution containing 80% N,N-dimethylformamide and 20% isopropanol. Following removal of the blank from the chemical solution, the solvent has been rapidly volatilized. During the procedure of solvent immersion and rapid drying, the surface layer 26 of the sulfone polymer 10 has flowed up onto the edges of copper circuitry 12 and 22.

**Claims**

1. A process for the preparation of etched metal patterns or printed wiring conductors on thermoplastic polymer base substrates, characterized in that said process comprises the steps of providing the metal clad thermoplastic substrate with at least one plated-through hole; removing unwanted portions of the metal cladding thus forming the metal pattern or printed wiring conductors; contacting the substrate with a solvent in which the said substrate material is at least partially soluble for a time period sufficient to permit the solvated substrate material to flow against and adhere to the edges of the metal pattern or printed wiring conductors, but insufficient to permit the solvated substrate material to flow onto the metal pattern or printed wiring conductors; and immediately evaporating the solvent from the surface of the substrate at a temperature at which the solvent rapidly volatilizes to stop said flow, leaving the edges of the metal pattern or printed wiring conductors adhered to the surface of the substrate at their intersection.

2. The process of Claim 1, wherein the metal clad thermoplastic substrate is annealed prior to removing unwanted portions of the metal cladding.

3. The process of Claim 1 or 2, wherein the unwanted portions are removed by an etching process.

4. The process of Claims 1 to 3, wherein the time period between discontinuing solvent exposure and beginning of drying is insufficient to give rise to the forming of a light haze or frosting of the treated surface, thus substantially restoring it to a smooth, translucent or transparent condition or, in the case of a thermoplastic substrate containing a pigment, its initial color.

FIG. 1A

FIG. 1B

FIG. 1C

FIG. 1D

FIG. 1E

FIG. 1F

FIG. 1G